Europäisches Patentamt

European Patent Office

Office européen des brevets

(19)

(11) **EP 0 595 159 B1**

(12) **EUROPÄISCHE PATENTSCHRIFT**

(45) Veröffentlichungstag und Bekanntmachung des Hinweises auf die Patenterteilung:
**29.12.1997  Patentblatt 1997/52**

(51) Int Cl.[6]: **C23C 16/44**, C23C 16/50, C03C 17/00

(21) Anmeldenummer: **93116837.1**

(22) Anmeldetag: **19.10.1993**

(54) **Verfahren und Vorrichtung zur Beschichtung der Innenfläche stark gewölbter im wesentlichen kalottenförmiger Substrate mittels CVD**

Process and apparatus for interior coating of strongly curved, essentially dome-shaped substrates by CVD

Procédé et appareillage pour revêtir par CVD l'intérieur des substrats fortement courbés sous la forme de calotte

(84) Benannte Vertragsstaaten:
**BE CH DE FR GB IT LI NL**

(30) Priorität: **26.10.1992  DE 4236056**
          **11.10.1993  DE 4334572**

(43) Veröffentlichungstag der Anmeldung:
**04.05.1994  Patentblatt 1994/18**

(73) Patentinhaber:
• **Schott Glaswerke**
  **55122 Mainz (DE)**
  Benannte Vertragsstaaten:
  **BE CH DE FR IT LI NL**
• **Carl-Zeiss-Stiftung**
  **trading as SCHOTT GLASWERKE**
  **55122 Mainz (DE)**
  Benannte Vertragsstaaten:
  **GB**

(72) Erfinder:
• **Mörsen, Ewald, Dr.**
  **D-64546 Mörfelden (DE)**
• **Vogt, Helge**
  **D-55299 Nackenheim (DE)**
• **Segner, Johannes, Dr.**
  **D-55442 Stromberg (DE)**

(56) Entgegenhaltungen:
**DE-C- 4 008 405          DE-C- 4 120 176**
**US-A- 3 524 590**

• **CRC Handbook of Chemistry and Physics, 62. Auflage, Seite F-51**

**Beschreibung**

Die Erfindung betrifft ein Verfahren zur Beschichtung der Innenfläche stark gewölbter, im wesentlichen kalottenförmiger Substrate mit einem dielektischen und/oder metallischen Schichtsystem mittels eines Plasma-CVD-Verfahrens, bei welchem die Reaktionsgase, welche die Schichtbildnermoleküle enthalten, durch wenigstens eine gegenüber dem Kalottenscheitelpunkt beabstandet von der zu beschichtenden Fläche angeordnete Gauseintrittsöffnung in die Reaktionskammer mit dem (n) zu beschichtenden Substrat(en) geleitet werden, und sodann in an sich bekannter Weise durch Erzeugung einer Reaktionszone an der zu beschichtenden Substratinnenfläche die Abscheidung des Schichtmaterials auf dem Substrat bewirkt wird. Des weiteren betrifft die Erfindung auch Vorrichtungen zur Durchführung des Verfahrens.

Ein Verfahren der eingangs genannten Art ist insbesondere zur Herstellung von Reflektoren geeignet. Ein solches Verfahren ist beispielsweise in der DE 40 08 405 C1 beschrieben.

Reflektoren bestehen in der Regel aus gewölbten, annähernd kalottenförmigen Substraten ("Kalotten"), meist aus Glas, mit einer innenseitigen Reflexionsbeschichtung, z.B. einer Kaltlichtspiegelbeschichtung. Insbesondere werden als Substrate üblicherweise durch Pressen geformte Glasrohlinge verwendet, welche auf ihrer äußeren Oberfläche bereits mit Lampenstutzen, den sogenannten Kalottenhälsen, für die elektrischen Anschlüsse versehen sind. Die Reflexionsbeschichtung kann aus einer metallischen Schicht, oder aber, wenn ein spezieller spektraler Verlauf des Reflexionsgrades gewünscht ist, aus einem dielektrischen Schichtsystem bestehen. Die Anforderungen an die optische Qualität solcher Schichten, insbesondere auch an die Gleichmäßigkeit ("Uniformität") der Beschichtung sind hoch.

Aus der DE 40 08 405 C1 ist bekannt, solche Reflektoren mittels eines Plasma-CVD-Verfahrens herzustellen. Plasma-CVD-Verfahren wie auch die Herstellung dielektrischer Schichtsysteme mit vorgegebenem spektralen Verlauf sind an sich bekannt und in der Patent- und sonstigen Literatur vielfältig beschrieben. Allerdings war es bis zu der Erfindung, die Gegenstand der DE 40 08 405 C1 ist, nicht möglich, Plasma-CVD-Verfahren zur Herstellung von Schichtsystemen von hoher optischer Qualität auch auf stark gewölbte Substrate, wie z. B. Kalotten, zur Herstellung von Reflektoren mit Reflexionsbeschichtungen anzuwenden. Zur Herstellung einer gleichmäßigen Beschichtung auf einem stark gewölbten Substrat ist es, wenn eine aufwendige Relativbewegung zwischen Substrat und Beschichtungszone vermieden werden soll, erforderlich, daß sich die schichtbildende Reaktionszone während des Beschichtungsprozesses über die gesamte zu beschichtende Fläche erstreckt. Hierzu sind großvolumige Plasmazonen erforderlich, da zur vollständigen Abdeckung der gesamten zu beschichtenden Fläche auch die von den stark gewölbten Substraten eingeschlossenen Hohlräume innerhalb des Plasmabereichs liegen müssen.

Mit zunehmender Dicke der Plasmazone über einer zu beschichtenden Fläche steigt aber die Wahrscheinlichkeit, daß sich nicht nur an der Grenzfläche Substrat/Gasraum, sondern im gesamten Gasraum in einer sogenannten Homogenreaktion Partikel bilden, welche sich dann als "Glasruß" auf der Substratoberfläche absetzen und in die abgeschiedenen Schichten miteingebaut werden. Diese zur Schichttrübung führende Partikelbildung, welche die Schichten für optische Anwendungen unbrauchbar macht, tritt insbesondere in den Randbereichen der Plasmazone auf, innerhalb welcher die Leistungsdichte im Plasma unterhalb eines kritischen Wertes gesunken ist.

Um die oben beschriebene Partikelbildung im Gasraum bei der Plasma-CVD-Beschichtung stark gewölbter Substrate zu unterdrücken, wird in der eingangs genannten DE 40 08 405 C1 vorgeschlagen, mittels eines sogenannten Verdrängungskörpers, welcher beispielsweise bei der Kalotteninnenbeschichtung in das Kalotteninnenvolumen eintaucht und eine Gestalt aufweist, die in etwa der Gestalt des gewölbten Substrats entspricht, die Dicke der zu reagierenden Gasschicht über der zu beschichtenden Fläche so zu begrenzen, daß das Ausmaß der in der Gasschicht während der Plasmaphase auftretenden Glasrußbildung für die gewünschte optische Schichtqualität unschädlich bleibt. Der Verdrängungskörper der DE 40 08 405 C1 hat somit u. a. die Aufgabe, die Randbereiche der Plasmazone mit geringer Leistungsdichte, innerhalb welcher die Glasrußbildung bevorzugt auftritt, auszublenden, d.h. die Schichtbildnermoleküle, die ohne die begrenzende Oberfläche des Verdrängungskörpers in den Randbereich des Plasmas eindringen und zur Partikelerzeugung beitragen würden, aufzufangen und in einer kompakten Schicht auf seiner Oberfläche festzuhalten. Die Zufuhr der Reaktionsgase erfolgt gemäß D 40 08 405 C1 durch den Verdrängungskörper hindurch, der hierzu einen Kanal aufweist, der in eine zentrale Gasaustrittsöffnung in seiner Stirnfläche mündet. Die Gasaustrittsöffnung ist somit gegenüber dem Kalottenscheitelpunkt beabstandet von der zu beschichtenden Fläche angeordnet.

Üblicherweise werden die Reaktionsgase bei CVD-Verfahren so geführt, daß sie langsam und kontinuierlich in die Reaktionskammer mit dem(n) zu beschichtenden Substrat(en) einströmen. Man ging bisher davon aus, daß Wirbel in den Gasströmen zu Schichtinhomogenitäten führen. Wirbel sollten daher um jeden Preis vermieden werden. So dient der in der DE 40 08 405 C1 beschriebene Verdrängungskörper auch nicht nur allein zur Begrenzung der Reaktionszone, sondern auch zur Herstellung einer langsamen und kontinuierlichen Strömung der Reaktionsgase an der zu beschichtenden Fläche entlang.

Nachteilig an dem bekannten Verfahren ist, daß es aufwendig durchzuführen ist. Der Verdrängungskörper, der in der Regel in nur geringem Abstand zur zu beschichtenden Fläche angeordnet wird, wird praktisch gleichdick mit dem Substrat mitbeschichtet. Es ist daher erforderlich, um ein allmähliches Zuwachsen des Spalts zwischen seiner substratseitigen Oberfläche und der Substratinnenfläche zu verhindern, daß er regelmäßig von der aufgewachsenen Schicht befreit wird. Insbesondere bei Anwendung eines Plasma- Impuls-CVD-Verfahrens würde die allmähliche Verringerung des Abstandes zwischen Verdrängungskörper und Substrat, d. h. die Verringerung der Dicke der zu reagierenden Gasschicht, zu einer unerwünschten Abnahme der Beschichtungsrate während des Beschichtungsprozesses führen. Ein weiterer Nachteil des bekannten Verfahrens ist, daß auch die Herstellung des Verdrängungskörpers sehr aufwendig ist, da er jeweils an die Gestalt des zu beschichtenden Substrats angepaßt werden muß.

Aufgabe der Erfindung ist, ein Verfahren der eingangs genannten Art so weiterzuentwickeln, daß es die oben beschriebenen Nachteile nicht aufweist. Das Verfahren soll Beschichtungen von hoher optischer Qualität sowie mechanischer, thermischer und chemischer Stabilität liefern und dennoch einfach und kostengünstig durchzuführen sein. Eine weitere Aufgabe der Erfindung besteht darin, Vorrichtungen zur Durchführung des Beschichtungsverfahrens bereitzustellen, welche sich durch einen möglichst einfachen Aufbau auszeichnen, welche auch bei unterschiedlichen Substratgeometrien ohne jeweilige Anpassung universell eingesetzt werden können und bei welchen eine Mitbeschichtung von Teilen der Reaktionskammer nicht zu einer Veränderung kritischer Abmessungen der Reaktionskammer führt.

Diese Aufgabe wird gelöst mit einem Verfahren mit allen Merkmalen des Patentanspruchs 1. Vorrichtungen zur Durchführung des erfindungsgemäßen Verfahrens sind in den Patentansprüchen 4 und 5 beschrieben.

Im Gegensatz zu den bekannten Plasma-CVD-Verfahren sieht die Erfindung vor, daß die Reaktionsgase in einem gerichteten Gasstrahl in die Reaktionskammer eingeleitet werden. Die Strömungsgeschwindigkeit muß dabei so hoch sein, daß bis zum Auftreffen des Gasstrahls auf der Substratinnenfläche am Kalottenscheitelpunkt keine wesentliche Strahldivergenz auftritt. Dies läßt sich dadurch erreichen, daß die Strömungsgeschwindigkeit so hoch gewählt wird, daß für das Produkt aus Reynoldszahl R des Gasstrahls in der Gaseintrittsöffnung und dem Abstand h zwischen Gaseintrittsöffnung und Kalottenscheitelpunkt gilt:

$$400 < R \times h \ [mm] < 4000 \qquad (1)$$

mit

$$R = r \times v \times d/n$$

r = Dichte des strömenden Mediums
v = Geschwindigkeit des strömenden Mediums
n = dynamische Zähigkeit des strömenden Mediums
d = Durchmesser der Gaseintrittsöffnung (h wird in mm eingegeben)

Gleichung (1) wurde mit Hilfe von für verschiedene Reynoldszahlen berechneten Strömungsprofilen sowie durch Experimente zur Uniformität von Beschichtungen in Abhängigkeit von der Reynoldszahl für unterschiedliche Kalottengeometrien, d.h. unterschiedliche Kalottengrößen empirisch ermittelt. Für die derzeitigen Anwendungen sind Kalotten mit einer Höhe (=Abstand zwischen Kalottenfuß und Scheitelpunkt) von 8 bis 100 mm von besonderem Interesse.

Es hat sich in überraschender Weise gezeigt, daß bei dieser Vorgehensweise gleichmäßige Beschichtungen, d.h. solche mit nahezu über die gesamte Substratfläche einheitlicher Schichtdicke, erzielt werden können. Insbesondere hat es sich auch gezeigt, daß bei Kalotten mit Kalottenhals die Geometrie der Querschnittsfläche des Kalottenhalses keinen Einfluß auf die Uniformität der Beschichtung hat. Dies könnte möglicherweise damit erklärt werden, daß sich in dem Kalottenhals ein Gaspolster ausbildet, das das gesamte Volumen des Kalottenhalses ausfüllt und an dessen Grenzfläche zur Reaktionskammer eine azimutal gleichmäßige Umlenkung des Gasstrahls erfolgt. Der Kalottenhals kann während der Beschichtung allerdings auch abgedeckt werden.

Ebenso überraschend ist es, daß mit dem erfindungsgemäßen Verfahren trotz fehlender räumlicher Begrenzung der Plasmazone durch geeignete Festkörperoberflächen auf einen Bereich mit gleichmäßig hoher Leistungsdichte Schichten von hoher optischer Qualität sowie mechanischer, thermischer und chemischer Stabilität erhalten werden. Eine Glasrußbildung findet nicht statt. Dies läßt sich, wie weiter unten noch anhand berechneter Strömungsprofile näher erläutert wird, u. U. durch die Ausbildung besonderer Strömungswirbel im Kalotteninnenvolumen bei erfindungsmäßiger Einleitung der Reaktionsgase erklären.

Eine geeignete Vorrichtung zur Durchführung des erfindungsgemäßen Verfahrens weist als Einrichtung zur Einleitung der Reaktionsgase eine Flachdüse auf, die im wesentlichen außerhalb des Kalotteninnenvolumens angeordnet ist, d. h. nicht oder nur geringfügig in das Kalotteninnenvolumen hineinragt, und die eine Gaseintrittsöffnung besitzt. Hierdurch kommt es auch bei einer Mitbeschichtung nicht zu einer Änderung kritischer Abmessungen im Reaktionsraumvolumen.

Ansonsten bestehen mit Ausnahme des Durchmessers der Gasaustrittsöffnung bzw. des Gesamtdurchmessers mehrerer Gasaustrittsöffnungen (hierunter soll der Durchmesser des resultierenden Gasstrahls, so wie er sich unmittelbar nach Austritt aus der Flachdüse ausbildet, verstanden werden) keine besonderen Anforderungen an die geometrische Gestalt der Flachdüse. Durch Profilierung der dem Beschichtungsraum zugewandten Seite der Flachdüse kann in gewissen Grenzen der Verlauf der Schichtdicke beeinflußt werden.

Nachfolgend wird die Erfindung anhand der Figuren näher erläutert:

Es zeigen:

Figur 1: eine Beschichtungsstation zur Innenbeschichtung einer einzelnen Kalotte zur Herstellung eines Reflektors mit einer Flachdüse zur Erzeugung eines gerichteten Gasstrahls nach der Erfindung,

Figur 2: die Beschichtungsstation von Figur 1 mit einer Flachdüse, welche zur besseren Ausrichtung des Gasstrahls an der Gasaustrittsöffnung mit einem rohrförmigen Fortsatz versehen ist und

Figur 3: ein berechnetes Strömungsprofil, welches die Strömungsverhältnisse der Reaktionsgase im Kalotteninnenvolumen bei Durchführung des erfindungsgemäßen Verfahrens zeigt.

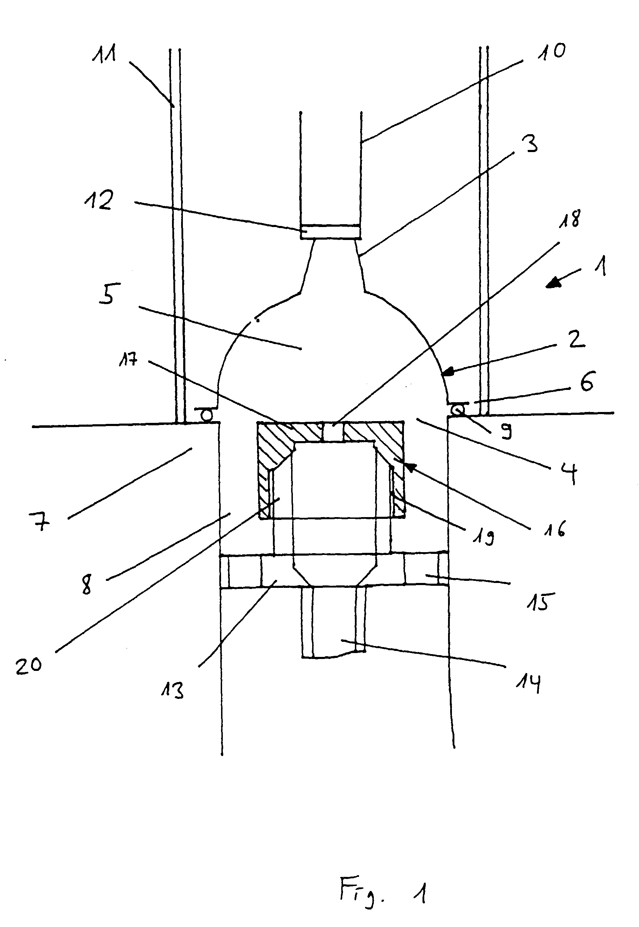

Man erkennt in Figur 1 eine Beschichtungsstation 1 einer Beschichtungsanlage zur Plasma-CVD-Beschichtung einer einzelnen Kalotte, bei welcher, wie aus der DE 40 08 405 C1 bekannt, die Kalotte selbst einen Teil der Reaktionskammer bildet. Zweckmäßigerweise weist eine Plasma-CVD-Anlage mehrere solcher Beschichtungsstationen 1 auf. Die Vorteile einer Einzelbeschichtungsstation gegenüber einer Reaktionskammer, in welcher mehrere zu beschichtenden Kalotten angeordnet und gemeinsam beschichtet werden, sind in der DE 40 08 405 C1 beschrieben.

In Figur 1 ist die zu beschichtende Kalotte mit 2 bezeichnet. Sie weist, da sie zur Herstellung eines Reflektors dient, einen Kalottenhals 3 auf.

Vor der Beschichtung werden die Substrate 2 üblicherweise einem Reinigungsprozeß unterzogen, wobei bestimmte Reinigungsverfahren, z.B. solche, bei denen die Kalotte 2 von einer Reinigungsflüssigkeit durchströmt wird, es erforderlich machen, den von der Formgebung herrührenden Verschluß am Kalottenhals 3 nach dem Pressen zu entfernen. Bei diesen sog. offenen Kalotten muß der Kalottenhals 3 vor Einbau der Kalotte 2 in eine Beschichtungsstation 1 mittels geeigneter Maßnahmen verschlossen werden.

Die Reaktionskammer 4 wird, wie oben beschrieben, durch das Kalotteninnenvolumen 5 selbst und ein an die Kalotte 2 angesetztes weiteres Teil gebildet. Dieses Teil kann, sowohl, so wie aus der DE 40 08 405 C1 bekannt, ein halbseitig offenes Glasgefäß, welches an den Kalottenfuß 6 angesetzt wird, sein; in Figur 1 ist jedoch eine Ausführungsform dargestellt, bei welcher die Kalotte 2 auf eine sog. Basisplatte 7, vorzugsweise aus einem metallischen Werkstoff, mit entsprechender Aussparung 8 für Gasein- und Gasaustrittsöffnungen, welche den unteren Teil der Reaktionskammer 4 bildet, aufgesetzt ist. Ein Dichtungsring 9 zwischen Kalottenfuß 6 und Basisplatte 7 sorgt für eine gasdichte Verbindung beider Teile. Diese Ausführungsform hat gegenüber dem aus der DE 40 08 405 C1 bekannten, angesetzten Gefäßteil den Vorteil der einfacheren Herstellung und Reinigung. Darüber hinaus bildet die Metallplatte 7 gleichzeitig eine Abschirmung gegen Mikrowellenstrahlung.

Die in der Figur gezeigte Beschichtungsstation 1 enthält des weiteren eine Mikrowellen-Innenleiter/Außenleiter-Anordnung zur Übertragung von Mikrowellenenergie in die Reaktionszone zur Zündung und Speisung des Plasmas. Die Vorteile eines PCVD-Abscheideverfahrens mittels mikrowellenangeregter Plasmen ist bekannt. Der Innenleiter ist mit 10, der Außenleiter mit 11 bezeichnet. Zwischen Innenleiter 10 und Kalottenhals 3 ist eine Dichtungsscheibe 12 angeordnet, welche zur Abdichtung des offenen Kalottenhalses dient.

Den Boden der Reaktionskammer 4 bildet in Figur 1 ohne Beschränkung der Allgemeinheit eine sog. Düsenplatte 13. Die Düsenplatte 13 besitzt in Figur 1 eine zentrale Gaseinlaßöffnung 14 und um diese Öffnung azimutal gleichmäßig verteilt angeordnete Gasauslaßöffnungen 15.

Der gerichtete Gasstrahl wird in der Vorrichtung von Figur 1 mittels einer sogenannten Flachdüse 16 erzeugt. Die Flachdüse 16 zeichnet sich dadurch aus, daß sie nicht oder nur geringfügig in das Kalotteninnenvolumen 5 hinein ragt. Sie besteht im wesentlichen aus einer Platte 17, deren Oberfläche plan, konvex oder konkav sein kann, und zur gezielten Beeinflussung der Strömungsverhältnisse im Kalotteninnenvolumen eine entsprechende Profilierung aufweisen kann. Durch konvexe Oberflächenbereiche der Flachdüse wird die Schichtdicke auf zugehörigen Substratbereichen erhöht, durch konkave reduziert. Der Zusammenhang zwischen den profilierten Bereichen der Flachdüse und den zu beeinflussenden Bereichen der Schicht auf der Kalotte ist komplex und wird jeweils empirisch ermittelt.

Die Flachdüse 16 kann integraler Bestandteil der Düsenplatte 13 sein. Sie kann aber auch eine Montagebohrung 19 aufweisen und leicht entnehmbar auf einen Konusfortsatz 20 der Düsenplatte 13 montiert, beispielsweise aufgesteckt werden. Dann ist dieses Bauteil zum Reinigen leicht ausbaubar. Anstelle des Konusfortsatzes 20 kann die Düsenplatte 13 aber auch einen Gewindefortsatz aufweisen, auf welchen die Flachdüse 16 leicht höhenverstellbar aufschraubbar ist.

Zur Herstellung einer gleichmäßigen Beschichtung auf einem (bzgl. der Kalottenachse rotationssymmetrischen) Substrat ist in Figur 1 die Flachdüse 16 mit der zentralen Öffnung 18 für den austretenden Gasstrahl zentrisch in der Reaktionskammer 4, d.h. in der Kalottenachse angeordnet. Man erkennt in Figur 1, daß der Gasstrahl auf den Scheitelpunkt der Kalotte, d. h. auf den Kalottenhals ausgerichtet ist.

Wie bereits oben erwähnt wurde, hat es sich in überraschender Weise gezeigt, daß die Gestalt des Kalottenhalses 3 keinerlei Einfluß auf die Gleichmäßigkeit der Beschichtung hat. So wurden selbst bei Kalottenhälsen mit unterschiedlichem rechteckigem Querschnitt durchaus gleichmäßige Beschichtungen erzielt, solange der Gasstrahl vollständig in den Kalottenhals eintrat. Um eine Innenbeschichtung des Kalottenhalses zu vermeiden, wird dieser jedoch vorzugsweise während der Beschichtung abgedeckt.

Des weiteren sollte, um eine gleichmäßige Beschichtung zu gewährleisten, auch die Anordnung der Gasein- bzw. Gasauslaßöffnungen 14/15 an die Geometrie des zu beschichtenden Substrats angepaßt sein. So befindet sich in Figur 1 die Gaseinlaßöffnung 14 im Mittelpunkt der Düsenplatte 13, gegenüber dem Scheitelpunkt der Kalotte, beabstandet von der zu beschichtenden Fläche, während mehrere Gasauslaßöffnungen 15 azimutal gleichmäßig um die Gaseinlaßöffnung verteilt angeordnet sind, so daß ein gleichmäßiges Absaugen der Reaktionsgase gewährleistet ist. Die Gasauslaßöffnungen 15 werden sinnvollerweise im einzelnen so ausgestaltet, daß sie in ihrer Gesamtheit näherungsweise einen um die Gaseinlaßöffnung 14 umlaufenden Ringspalt bilden. Im übrigen können weitere geeignete geometrische Anordnungen der Gasauslaßöffnungen und die Gaseinlaßöffnung vom Fachmann durch einfaches Ausprobieren, ohne erfinderisches Zutun leicht ermittelt werden.

Die Gaseintrittsöffnung (18) der Flachdüse (16) kann sich bei entsprechend grobem Durchmesser (z. B. bei der Beschichtung großer Kalotten) auch aus mehreren einzelnen Öffnungen zusammensetzen, beispielsweise auch als Gasdusche mit einer Vielzahl aneinander angrenzender kleinerer Öffnungen ausgebildet sein. Zur Berechnung der Reynoldszahl wird in diesem Fall nicht der Durchmesser der kleineren Öffnungen, sondern der Durchmesser des gesamten Gaseintrittsbereichs der Gasdusche, d.h. der Einfachheit halber der Durchmesser des resultierenden Gasstrahls in unmittelbarer Nähe der Gaseintrittsöffnungen bei Verlassen der Düse herangezogen.

Die Verwendung der oben beschriebenen Flachdüse hat den Vorteil, daß sie nur sehr selten gereinigt werden muß. Zwar wird die Plattenoberfläche ebenfalls wie auch der Verdrängungskörper aus der DE 40 08 405 C1 mitbeschichtet, die entstandene Schicht hat jedoch auch bei sehr großer Dicke auf die Funktion und die Güte der Kalottenbeschichtung keinen Einfluß, da sie keine kritischen Abmessungen der Reaktionskammer verändert: die Flachdüse liegt entweder völlig außerhalb des Kalotteninnenvolumens (5) oder nimmt nur einen sehr geringen Teil desselben ein. Insbesondere hat es sich in vorteilhafter Weise gezeigt, daß die Bohrung selbst und ihre unmittelbare Umgebung praktisch nicht mitbeschichtet werden. Die auf der Flachdüse in zahlreichen Beschichtungsprozessen aufgewachsene Schicht muß erst nach Standzeiten, die erheblich länger sind, als die aus dem Stand der Technik bekannten, entfernt werden; nämlich dann, wenn eine Ablösung von Flitterchen der Beschichtung zu befürchten ist. Im allgemeinen sind daher die Standzeiten eines Düsenkörpers gegenüber den aus dem Stand der Technik bekannten Verdrängungskörpern um einen Faktor 10 bis 100 größer.

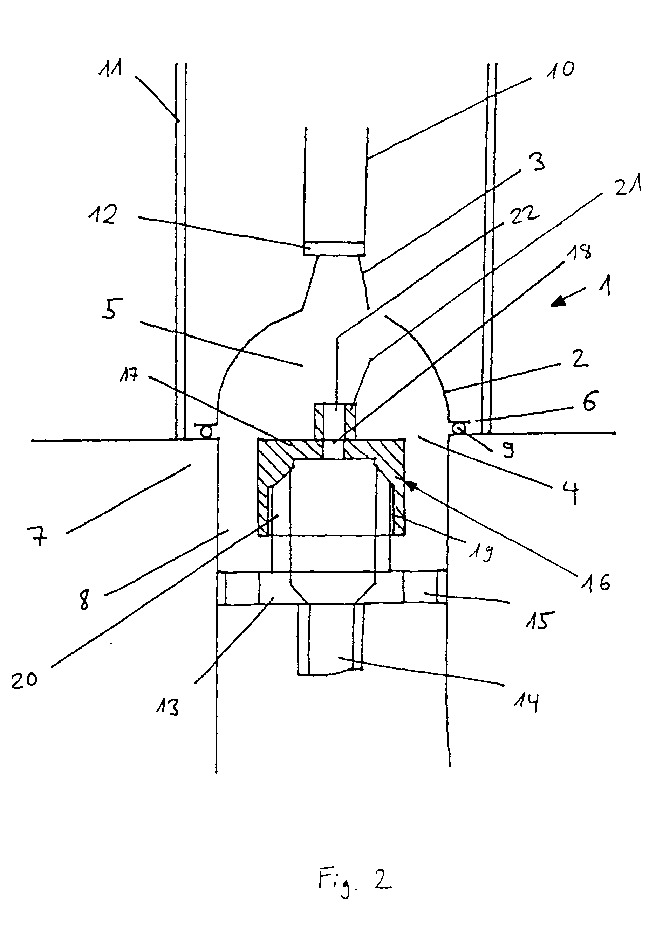

In Figur 2 besteht die Einrichtung zum Zuführen der Reaktionsgase aus einer Flachdüse 16 mit einem rohrförmigen Fortsatz 21, dessen Innenbohrung 22 mit der Gasaustrittsöffnung 18 in Verbindung steht. Der rohrförmige Fortsatz 21 verhindert wirksam ein frühzeitiges Aufweiten des Gasstrahls (und sorgt daher für eine bessere Strahlführung). Auch der rohrförmige Fortsatz 21 nimmt nur einen geringen Teil des Kalotteninnenvolumens 5 ein, so daß auch bei dieser Vorrichtungsvariante eine Mitbeschichtung der Düse zu keiner Änderung kritischer Abmessungen im Reaktionsraum führt. Die Verwendung des rohrförmigen Fortsatzes 21 auf der Flachdüse 16 hat den Vorteil, daß die sich ausbildenden Wirbel in Richtung Kalottenhals verlagert werden, so daß über die Länge des Rohres die Ausdehnung des Beschichtungsbereiches eingestellt werden kann.

Die in den Figuren 1 und 2 dargestellte Flachdüse, welche zur Durchführung des erfindungsgemäßen Verfahrens besonders geeignet ist, ist ohne Beschränkung der Allgemeinheit jeweils bei Verwendung in Einzelbeschichtungsstationen für Kalotten gezeigt. Das erfindungsgemäße Verfahren läßt sich aber mit der oben beschriebenen Flachdüse auch in herkömmlichen Reaktionskammern, in welchen mehrere Kalotten gemeinsam, d.h. gleichzeitig, beschichtet werden, durchführen.

Geeignete Abmessungen für die Flachdüse lassen sich leicht ohne erfinderisches Zutun, beispielsweise experimentell, ermitteln. Zur Erzeugung des für die erfolgreiche Durchführung des erfindungsgemäßen Verfahrens notwendigerweise gerichteten Gasstrahls wird der Durchmesser der Gaseintrittsöffnung der Flachdüse in Abhängigkeit von den für die Ausbildung eines Gasstrahls verantwortlichen Beschichtungsparametern (z. B. Massenfluß, Druck) so eingestellt, daß die eingangs beschriebene Beziehung zwischen Reynoldszahl R und Abstand h von Gaseintrittsöffnung zu Kalottenscheitelpunkt erfüllt ist. Ebenso lassen sich aber auch bei vorgegebenem Lochdurchmesser die Beschichtungsparameter in gewissen Grenzen anpassen.

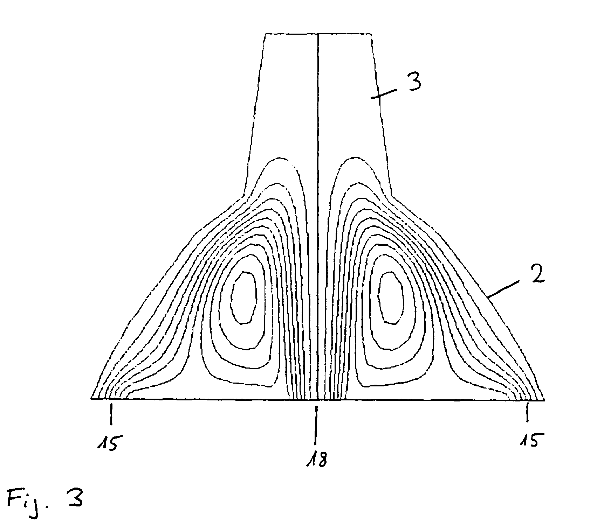

Figur 3 zeigt zur Darstellung der Strömungsverhältnisse in der Kalotte bei Durchführung des erfindungsgemäßen Verfahren ein mit Hilfe eines kommerziellen Simulationsprogramms zur Berechnung von Strömungen in inkompressiblen Medien berechnetes Strömungsprofil. Die Berechnung wurde für eine kleine Kalotte (Durchmesser 50 mm) durchgeführt, wobei für den Durchmesser der Düsenbohrung 18 ein Wert von 6 mm, für den Außendurchmesser des Absaugkanals 15 von 43 mm, für den Innendurchmesser ein Wert von 35 mm angenommen wurde. Des weiteren wurde der Berechnung ein Gasmassenfluß (überwiegend $O_2$) von 174 sccm zugrundegelegt. Man erkennt in der Figur den durch die Gaseintrittsöffnung 18 eintretenden Gasstrahl, der auf den Kalottenscheitelpunkt ausgerichtet ist. Am Kalottenscheitelpunkt wird der Gasstrahl umgelenkt und es kommt zur Ausbildung der dargestellten Wirbel. Es hat sich gezeigt, daß eine gleichmäßige homogene und dichte Beschichtung in der Kalotte nur dann erreicht wird, wenn die in Figur 3 dargestellten Strömungsverhältnisse in der Kalotte vorliegen. Dies läßt sich möglicherweise dadurch erklären, daß die Gaswirbel, die vermutlich überwiegend aus verbrauchtem Reaktionsgas bestehen, die Funktion eines Verdrängungskörpers übernehmen, d. h. die Dicke der zu reagierenden Gasschicht über der zu beschichtenden Fläche begrenzen und für eine laminare Strömung der frischen Reaktionsgase an der zu beschichtenden Fläche entlang sorgen: da die Gaswirbel wohl überwiegend an schichtbildendem Material verarmt sind, tragen sie selbst vermutlich nichts oder nur wenig zur Beschichtung bei; darüber hinaus werden, wie man leicht sieht, die frischen Reaktionsgase auf dem Rücken der Gaswirbel in einer laminaren Strömung an der zu beschichtenden Fläche entlanggeführt, wobei die Dicke dieser Gasschicht von der Höhe der Wirbel abhängt.

Simulationsrechnungen und Experimente haben nun gezeigt, daß sich die Ausbildung solcher Gaswirbel über die Reynoldszahl der Gasströmung in der Gaseintrittsöffnung und den Abstand von Gaseintrittsöffnung zu Kalottenscheitelpunkt charakterisieren läßt. Hieraus resultiert die eingangs angegebene Beziehung (1). Solange sich das Produkt aus Reynoldszahl R und Abstand h in den in Gleichung (1) angegebenen Grenzen bewegt, kommt es zur Ausbildung der oben beschriebenen Gaswirbel, woraus eine homogene, dichte und gleichmäßige Beschichtung resultiert.

Die Strömungsverhältnisse in der Kalotte lassen sich in Abhängigkeit von den oben genannten Parametern wie folgt charakterisieren: Bei vorgegebenem Abstand h kommt es mit steigender Reynoldszahl R (beispielsweise durch Erhöhung des Massenflusses der Reaktionsgase bei konstantem Durchmesser der Gaseintrittsöffnung(en) oder durch Verringerung des Durchmessers bei konstantem Massenfluß) zur Ausbildung von Gaswirbeln am Kalottenfuß. Mit weiter zunehmender Reynoldszahl wandern die Gaswirbel in der Kalotte nach oben. Steigt die Reynoldszahl auf noch höhere Werte an, ist die Strömung entlang der zu beschichtenden Fläche nicht mehr laminar. Ähnliche Überlegungen lassen sich auch für die Verhältnisse bei veränderlichem Abstand h bei fester Reynoldszahl R anstellen.

Für das in DE 40 08 405 C1 beschriebene Verfahren, bei welchem die Reaktionsgase über den Verdrängungskörper langsam in das Reaktionsraumvolumen einströmen, lassen sich zum Vergleich ebenfalls Werte für das Produkt aus Reynoldszahl R und Abstand h bei üblichen Beschichtungsbedingungen abschätzen. Diese betragen nur etwa 1/10 der in Gleichung (1) angegebenen unteren Grenze.

Vorzugsweise wird bei dem erfindungsgemäßen Verfahren ein Plasma-Impuls-CVD-Verfahren eingesetzt. Plasma-Impuls-CVD-Verfahren zur Herstellung dielektrischer und/oder metallischer Schichtsysteme von hoher optischer Qualität sowie chemischer, thermischer und mechanischer Beständigkeit sind an sich bekannt und beispielsweise auch für die Kalottenbeschichtung in der eingangs erwähnten DE 40 08 405 C1 beschrieben. Insbesondere sind auch die Vorteile eines Mikrowellen-Plasma-Impuls-CVD-Verfahrens hinlänglich bekannt und beispielsweise in der oben zitierten Schrift ausführlich erläutert. Es hat sich gezeigt, daß die bekannten Vorteile eines (Mikrowellen) Plasma-Impuls-CVD-Verfahrens auch bei der Durchführung des erfindungsgemäßen Verfahrens erhalten bleiben.

Die Flachdüse nach der Erfindung wie auch die übrigen Teile der Reaktionskammer der Einzelbeschichtungsanlage (mit Ausnahme der Kalotte selbst) sollten aus einem Material bestehen, das ausreichend temperaturbeständig und vakuumtauglich ist, das beständig ist gegen den Angriff chemisch aggressiver Prozeßgase und das möglichst nicht oder nur wenig mikrowellenabsorbierend ist. Materialien, die diese Eigenschaften in sich vereinigen, sind insbesondere Metalle, beispielsweise Aluminium.

Das erfindungsgemäße Verfahren ist nicht nur auf den Einsatz bei im mathematischen Sinne streng kalottenförmigen Substraten beschränkt. Asphärische Substrate, auch nicht streng rotationssymmetrische, können auch beschichtet werden.

Nachfolgend wird die Erfindung anhand eines Ausführungsbeispiels näher erläutert:

Das folgende Beispiel soll die Möglichkeiten einer Flachdüse bei der Herstellung einer Kaltlichtverspiegelung auf der Innenseite eines kalottenförmigen Glaspreßlings mit Kalottenhals verdeutlichen. Als Beschichtungsverfahren wurde das Plasma-Impuls-CVD-Verfahren eingesetzt.

Es wurde ein kalottenförmiges Substrat aus Glas mit einem Außendurchmesser am Kalottenfuß von 50 mm und einer Höhe bis zum Hals von 20 mm beschichtet. Die Beschichtung wurde in einer Kalottenbeschichtungsstation wie in Figur 1 dargestellt vorgenommen. Es wurde eine Flachdüse mit den folgenden Abmessungen verwendet: Durchmesser 30 mm, Wandstärke 3 mm, Durchmesser der zentralen Bohrung 4 mm. Die Oberfläche der Düse befand sich, so wie in Figur 1 dargestellt, etwa in Höhe des Kalottenfußes. Die Flachdüse war auf einen konusförmigen Fortsatz der Düsenplatte aufgesteckt. Der Abstand h der Gaseintrittsöffnung zum Kalottenscheitelpunkt betrug 20 mm. Durch eine näherungsweise kreisringförmige, konzentrisch zur Flachdüse in der Düsenplatte angeordnete Gasaustrittsöffnung wurden die verbrauchten Reaktionsgase abgesaugt. Für die hochbrechenden Schichten wurde $TiO_2$, für die niedrigbrechenden Schichten $SiO_2$ als Schichtmaterial

gewählt. Daher wurden während der Beschichtung zu einem $O_2$-Massenfluß abwechselnd HMDSO ($C_6H_{18}OSi_2$) für die $SiO_2$-Schicht und $TiCl_4$ für die $TiO_2$-Schicht zudotiert. Bei der Beschichtung lag der Druck in der Reaktionskammer bei etwa 0,7 mbar, die Temperatur der Kalotte betrug etwa 90°C. Der $O_2$-Massenfluß lag bei etwa 200 sccm, der HMDSO-Massenfluß bei etwa 3,6 sccm und der $TiCl_4$-Massenfluß bei etwa 3,0 sccm. Die übrigen Verfahrensparameter betrugen: Mikrowellenfrequenz 2,45 GHz, mittlere Mikrowellenleistung 75 W, Impulsdauer 0,6 ms, Impulspause 20 ms.

Zur Überprüfung von Gleichung (1) wird im folgenden die Reynoldszahl R für das Ausführungsbeispiel berechnet. Hierzu wird die eingangs angegebene Gleichung für R wie folgt umgeformt:

Die mittlere Geschwindigkeit v im Lochquerschnitt beträgt:

$$v = (4 \times Q_0 \times p_0/p) / (\pi \times d^2),$$

die Dichte r bei einem Druck p:

$$r = r_0 \times p / p_0,$$

wobei $Q_0$, $p_0$ und $r_0$ der Massenfluß, der Druck und die Dichte unter Normalbedingungen sind. Durch Einsetzen von v und r in die obige Gleichung für R erhält man:

$$R = 4 \times r_0 \times Q_0 / (\pi \times d \times n)$$

$$\approx 1,52 \times Q_0[\text{sccm}] / d[\text{mm}]$$

Die obige Vereinfachung gilt für Sauerstoff ($r_0=1,429$ kg/$m^3$; $n=1,92 \cdot 10^{-5}$ Pascal·sec), der wesentlicher Bestandteil des Beschichtungsgases ist und damit dessen Eigenschaften maßgeblich bestimmt.

Setzt man die oben angegebenen Werte für Massenfluß und Durchmesser der Düse nun in die vereinfachte Gleichung für R ein, so erhält man: R = 76 bzw. mit dem obigen Abstand h: R x h = 1520 Gleichung (1) ist damit für das Ausführungsbeispiel erfüllt.

Insgesamt wurden auf der Kalotteninnenfläche 23 Schichten, abwechselnd bestehend aus $SiO_2$ und $TiO_2$ abgeschieden. Die Beschichtung war gleichmäßig, kompakt und von hoher optischer Qualität. Die so hergestellte Kalotte mit Kaltlichtverspiegelung ist insbesondere zur Verwendung als Reflektor für die Objekt- und Raumbeleuchtungstechnik geeignet.

In einem weiteren Ausführungsbeispiel wurde mit den gleichen Beschichtungsparametern und Abmessungen von Substrat und Beschichtungsstation wie in dem obigen Ausführungsbeispiel eine weitere Kalotte beschichtet, wobei eine Flachdüse mit rohrförmigem Fortsatz verwendet wurde. Die Abmessungen des rohrförmigen Fortsatzes waren: Länge 5 mm, Außendurchmesser 6 mm, Innendurchmesser 4 mm.

Es wurde, wie im obigen Ausführungsbeispiel, eine gleichmäßige, kompakte Beschichtung von hoher optischer Qualität erreicht.

Das erfindungsgemäße Verfahren hat den Vorteil, daß die Standzeiten der Beschichtungsanlagen wesentlich höher sind, als bei bei herkömmlichen Anlagen. Es können in den Beschichtungsanlagen einfache Bauteile verwendet werden, wie z.B. die oben beschriebenen Düsenkörper, die aufgrund ihrer einfachen geometrischen Gestalt nicht nur preiswert zu fertigen, sondern auch leicht zu reinigen sind. Da die erfindungsgemäßen Düsenkörper bei vernünftiger Dimensionierung selbst bei Mitbeschichtung keine kritischen Abmessungen der Reaktionskammern berühren, sind sie auch bei verschiedenen Substratgeometrien universell ohne jeweilige Anpassung einsetzbar. Auch entfällt die Notwendigkeit aufwendiger Reinigungsprozeduren.

**Patentansprüche**

1. Verfahren zur Beschichtung der Innenfläche stark gewölbter, im wesentlichen kalottenförmiger Substrate mit einem dielektrischen und/ oder metallischen Schichtsystem mittels eines Plasma-CVD-Verfahrens, bei welchem die Reaktionsgase, welche die Schichtbildnermoleküle enthalten, durch wenigstens eine gegenüber dem Kalottenscheitelpunkt beabstandet von der zu beschichtenden Fläche angeordnete Gaseintrittsöffnung in die Reaktionskammer mit dem(n) zu beschichtenden Substrat(en) geleitet werden
und sodann in an sich bekannter Weise durch Erzeugung einer Reaktionszone an der zu beschichtenden Substratinnenfläche die Abscheidung des Schichtmaterials auf dem Substrat bewirkt wird,
**dadurch gekennzeichnet,**
daß die Reaktionsgase zur Herstellung einer gleichmäßigen Beschichtung mit einer solch hohen Geschwindigkeit in die Reaktionskammer eingeleitet werden, daß für das Produkt aus der Reynoldszahl R des Gasstrahls in der Gaseintrittsöffnung und dem Abstand h zwischen der Gaseintrittsöffnung und dem Kalottenscheitelpunkt gilt:

$$400 < R \times h \, [\text{mm}] < 4000$$

2. Verfahren nach Anspruch 1,
**dadurch gekennzeichnet,**
daß das Verfahren mittels eines Plasma-Impuls-CVD-Verfahrens durchgeführt wird.

3. Verfahren nach Anspruch 1 oder 2,

**dadurch gekennzeichnet,**
daß das Plasma mittels Mikrowellen angeregt wird.

4. Vorrichtung zur Durchführung des Verfahrens nach wenigstens einem der Ansprüche 1 bis 3,

mit einer Reaktionskammer zum Anordnen des (r) zu beschichtenden Substrats(e),
mit Einrichtungen zum Zu- und Abführen der frischen bzw. verbrauchten Reaktionsgase in die bzw. aus der Reaktionskammer, wobei die Einrichtung zum Zuführen der Reaktionsgase Gaseintrittsöffnungen aufweisen, die jeweils gegenüber den Kalottenscheitelpunkten und beabstandet von den zu beschichtenden Flächen angeordnet sind,
und mit Mitteln zur Erzeugung eines Plasmas zwecks Bildung von Reaktionszonen an den zu beschichtenden Substratinnenflächen

**dadurch gekennzeichnet,**

daß die Einrichtung zum Zuführen der Reaktionsgase eine Flachdüse (16) ist, welche nicht oder nur geringfügig in das Kalotteninnenvolumen hineinragt und welche auf der dem Substrat zugewandten Seite eine Platte (17) mit einer Gaseintrittsöffnung (18) zum Eintritt des gerichteten Gasstrahls in die Reaktionskammer (4) mit ausreichend hoher Geschwindigkeit besitzt.

5. Vorrichtung zur Durchführung des Verfahrens nach wenigstens einem der Ansprüche 1 bis 3,

mit einer Reaktionskammer zum Anordnen des (r) zu beschichtenden Substrats(e),
mit Einrichtungen zum Zu- und Abführen der frischen bzw. verbrauchten Reaktionsgase in die bzw. aus der Reaktionskammer, wobei die Einrichtung zum Zuführen der Reaktionsgase Gaseintrittsöffnungen aufweisen, die jeweils gegenüber den Kalottenscheitelpunkten und beabstandet von den zu beschichtenden Flächen angeordnet sind,
und mit Mitteln zur Erzeugung eines Plasmas zwecks Bildung von Reaktionszonen an den zu beschichtenden Substratinnenflächen

**dadurch gekennzeichnet,**

daß die Einrichtung zum Zuführen der Reaktionsgase eine Flachdüse (16) aufweist, welche nicht oder nur geringfügig in das Kalotteninnenvolumen hineinragt und die auf der dem Substrat zugewandten Seite eine Platte (17) mit einer Gaseintrittsöffnung (18) zum Eintritt des gerichteten Gasstrahls in die Reaktionskammer (4) mit ausreichend hoher Geschwindigkeit besitzt, sowie an der Gaseintrittsöffnung (18) der Flachdüse (16) zur besseren Ausrichtung des Gasstrahls einen in das Kalotteninnenvolumen hineinragenden, rohrförmigen Fortsatz (21).

6. Vorrichtung nach Anspruch 4 oder 5,
**dadurch gekennzeichnet,**
daß die Platte (17) eine Profilierung aufweist.

7. Vorrichtung nach wenigstens einem der Ansprüche 4 bei 6,
**dadurch gekennzeichnet,**
daß die Gaseintrittsöffnung (18) als Gasdusche ausgebildet ist.

8. Vorrichtung nach wenigstens einem der Ansprüche 4 bis 7,
**dadurch gekennzeichnet,**
daß die Flachdüse (16) auf einen Konusfortsatz (20) der Düsenplatte (13) in der Reaktionskammer (4) montiert ist.

9. Vorrichtung nach wenigstens einem der Ansprüche 4 bis 8,
**dadurch gekennzeichnet,**
daß die Mittel zur Erzeugung der Reaktionszone über der zu beschichtenden Substratinnenfläche eine Mikrowellen-Innenleiter/Außenleiter- Anordnung (10/11) sind, welche außerhalb der Reaktionskammer (4) von oben auf die Kalotte (2) aufgesetzt wird.

10. Vorrichtung nach wenigstens einem der Ansprüche 4 bis 9,
**dadurch gekennzeichnet,**
daß das im wesentlichen kalottenförmige Substrat (2) einen Teil der Reaktionskammer (4) bildet.

**Claims**

1. Process for coating the inner surface of strongly curved, essentially dome-shaped substrates with a dielectric and/or metallic coating system by means of a plasma CVD method, in which the reaction gases which contain the coating molecules are directed into the reaction chamber with the substrate(s) to be coated through at least one gas-entry opening arranged opposite the apex of the dome and at a distance from the surface to be coated, and then the deposition of the coating material on the substrate is effected in a way known per se by producing a reaction zone on the substrate inner surface to be coated, characterized in that, for producing a uniform coating, the reaction gases are introduced into the reaction chamber at such a high speed that the following applies for the product of the Reynolds number R of the gas stream in the gas-entry opening and the distance h between the gas-entry opening and the apex of the dome:

$$400 < R \times h \, [mm] < 4000$$

2. Process according to Claim 1, characterized in that the process is carried out by means of a plasmapulse CVD method.

3. Process according to Claim 1 or 2, characterized in that the plasma is excited by means of microwaves.

4. Apparatus for carrying out the process according to at least one of Claims 1 to 3, having a reaction chamber for arranging the substrate(s) to be coated, having devices for feeding in and carrying away the fresh and used reaction gases into and out of the reaction chamber, the device for feeding in the reaction gases having gas-entry openings, which in each case are arranged opposite the apexes of the domes and at a distance from the surfaces to be coated, and having means for producing a plasma for the purpose of forming reaction zones on the substrate inner surfaces to be coated, characterized in that the device for feeding in the reaction gases is a flat nozzle (16) which does not project into the inner volume of the dome, or does so only slightly, and which has on the side facing the substrate a plate (17) with a gas-entry opening (18) for the entry of the directed gas stream into the reaction chamber (4) at adequately high speed.

5. Apparatus for carrying out the process according to at least one of Claims 1 to 3, having a reaction chamber for arranging the substrate(s) to be coated, having devices for feeding in and carrying away the fresh and used reaction gases into and out of the reaction chamber, the device for feeding in the reaction gases having gas-entry openings, which in each case are arranged opposite the apexes of the domes and at a distance from the surfaces to be coated, and having means for producing a plasma for the purpose of forming reaction zones on the substrate inner surfaces to be coated, characterized in that the device for feeding in the reaction gases has a flat nozzle (16) which does not project into the inner volume of the dome, or does so only slightly, and which has on the side facing the substrate a plate (17) with a gas-entry opening (18) for the entry of the directed gas stream into the reaction chamber (4) at adequately high speed, and also a tubular continuation (21), projecting into the inner volume of the dome, at the gas-entry opening (18) of the flat nozzle (16), for better alignment of the gas stream.

6. Apparatus according to Claim 4 or 5, characterized in that the plate (17) has a profiling.

7. Apparatus according to at least one of Claims 4 to 6, characterized in that the gas-entry opening (18) is designed as a gas spray.

8. Apparatus according to at least one of Claims 4 to 7, characterized in that the flat nozzle (16) is fitted onto a conical continuation (20) of the nozzle plate (13) in the reaction chamber (4).

9. Apparatus according to at least one of Claims 4 to 8, characterized in that the means for producing the reaction zone over the substrate inner surface to be coated are a microwave inner conductor/outer conductor arrangement (10/11), which is placed onto the dome (2) from above, outside the reaction chamber (4).

10. Apparatus according to at least one of Claims 4 to 9, characterized in that the essentially dome-shaped substrate (2) forms part of the reaction chamber (4).

## Revendications

1. Procédé de revêtement de la surface intérieure de substrats fortement courbés, essentiellement en forme de calotte, par un système de couches diélectriques et/ou métalliques, au moyen d'un procédé CVD au plasma, dans lequel les gaz de réaction, qui contiennent les molécules formant la couche, sont dirigés dans la chambre de réaction avec le ou les substrats à recouvrir, par au moins un orifice d'entrée de gaz disposé face au sommet de la calotte à une certaine distance de la surface à revêtir,

   et dans lequel la précipitation du matériau de la couche est ensuite provoquée sur le substrat, d'une manière connue en soi, par la production d'une zone de réaction à la surface intérieure du substrat à revêtir,
   caractérisé en ce que
   les gaz de la réaction, pour fabriquer un revêtement régulier, sont introduits dans la chambre de réaction avec une vitesse élevée telle, que le produit du nombre de Reynolds R du jet de gaz dans l'orifice d'entrée des gaz et de l'intervalle h entre l'orifice d'entrée de gaz et le sommet de la calotte vaut :

   $$400 < R \times h \, [mm] < 4000$$

2. Procédé suivant la revendication 1, caractérisé en ce que

le procédé est réalisé au moyen d'un procédé CVD par impulsion de plasma.

3. Procédé suivant la revendication 1 ou 2, caractérisé en ce que le plasma est engendré au moyen de micro-ondes.

4. Appareillage pour la réalisation du procédé suivant l'une au moins des revendications 1 à 3,

    comprenant une chambre de réaction pour disposer le ou les substrats à revêtir, comprenant des dispositifs pour l'introduction et la sortie des gaz de réaction frais ou usés dans ou hors de la chambre de réaction, le dispositif d'introduction des gaz de réaction présentant des orifice d'entrée de gaz chaque fois disposés en face du sommet de la calotte et à une certaine distance des surfaces à revêtir, et comprenant des moyens pour produire un plasma en vue de former des zones de réaction sur la surface intérieure des substrats à revêtir,

    caractérisé en ce que

    le dispositif d'introduction des gaz de réaction est une buse plate (16), qui ne dépasse pas ou seulement légèrement dans le volume interne de la calotte et qui possède, sur sa face tournée vers le substrat, une plaque (17) pourvue d'un orifice d'entrée de gaz (18) pour l'entrée du jet de gaz amené dans la chambre de réaction (4) avec une vitesse suffisamment élevée.

5. Appareillage pour la réalisation du procédé suivant l'une au moins des revendications 1 à 3,

    comprenant une chambre de réaction pour disposer le ou les substrats à revêtir, comprenant des dispositifs pour l'introduction et la sortie des gaz de réaction frais ou usés dans ou hors de la chambre de réaction, le dispositif d'introduction des gaz de réaction présentant des orifices d'entrée de gaz chaque fois disposés en face du sommet de la calotte et à une certaine distance des surfaces à revêtir, et comprenant des moyens pour produire un plasma en vue de former des zones de réaction sur la surface intérieure des substrats à revêtir,

    caractérisé en ce que

    le dispositif d'introduction des gaz de réaction présente une buse plate (16), qui ne dépasse pas ou seulement légèrement dans le volume interne de la calotte et qui possède, sur sa face tournée vers le substrat, une plaque (17) pourvue d'un orifice d'entrée de gaz (18) pour l'entrée du jet de gaz amené dans la chambre de réaction (4) avec une vitesse suffisamment élevée, ainsi que, à l'orifice d'entrée de gaz (18) de la buse plate (16), un prolongement en forme de tuyau (21) pénétrant dans le volume interne de la calotte pour une meilleure orientation du jet de gaz.

6. Appareillage suivant la revendication 4 ou 5, caractérisé en ce que la plaque (17) présente un profilage.

7. Appareillage suivant l'une au moins des revendications 4 à 6, caractérisé en ce que l'orifice d'entrée de gaz (18) est en forme de douche à gaz.

8. Appareillage suivant l'une au moins des revendications 4 à 7, caractérisé en ce que la buse plate (16) est montée sur un prolongement conique (20) de la plaque d'injecteur (13) dans la chambre de réaction (4).

9. Appareillage suivant l'une au moins des revendications 4 à 8, caractérisé en ce que le moyen de produire les zones de réaction sur la surface interne du substrat à revêtir est un arrangement de conducteurs intérieur et extérieur de micro-ondes (10/11), qui est posé à l'extérieur de la chambre de réaction (4) au-dessus de la calotte (2).

10. Appareillage suivant l'une au moins des revendications 4 à 9, caractérisé en ce que le substrat essentiellement en forme de calotte (2) forme une partie de la chambre de réaction (4).

Fig. 1

Fig. 2

Fig. 3